# FASCICULE DE BREVET EUROPEEN

(11) **EP 0 887 843 B1**
(45) Date de publication et mention de la délivrance du brevet: **15.09.2010**
(21) Numéro de dépôt: 98401432.4
(22) Date de dépôt: 12.06.1998
(51) Int. Cl.: H01L 21/28, H01L 29/49, H01L 21/3213

(54) **Procédé d'obtention d'un transistor à grille en silicium-germanium**
Verfahren zur Herstellung eines Transistors mit einem Silizium-Germanium-Gatter
Method of manufacturing a transistor with a silicon-germanium gate

(30) Priorité: 25.06.1997 FR 9707938
(43) Date de publication de la demande: 30.12.1998
(73) Titulaire: Fahrenheit Thermoscope LLC, Las Vegas, NV 89119 (US)
(72) Inventeur: Sagnes, Isabelle, 75015 Paris (FR)
(74) Mandataire: Small, Gary James

(56) Documents cités:
- OZTURK M C ET AL: "Rapid thermal chemical vapor deposition of germanium and germanium/silicon alloys on silicon: new applications in the fabrication of MOS transistors" RAPID THERMAL AND INTEGRATED PROCESSING SYMPOSIUM, ANAHEIM, CA, USA, 30 APRIL-3 MAY 1991, pages 223-234, XP000198032 1991, PITTSBURGH, PA, USA, MATER. RES. SOC, USA
- KISTLER N ET AL: "SYMMETRIC CMOS IN FULLY-DEPLETED SILICON-ON-INSULATOR USING P+- POLYCRYSTALLINE SI-GE GATE ELECTRODES" IEDM,5 décembre 1993, pages 727-730, XP000481716

## Description

L'invention concerne les transistors à effet de champ à grille isolée silicium-germanium, c'est-à-dire présentant une couche de silicium-germanium, éventuellement de germanium pur, (Si₁₋ₓGeₓ où 0 < x ≤ 1), et en particulier celle présentant une concentration de germanium comprise entre 50 et 100% (0,5 ≤ x ≤1).

Dans les technologies CMOS actuelles, c'est-à-dire présentant des largeurs de grille supérieures ou égales à 0,25 µm, la grille des transistors à effet de champ est en silicium polycristallin ou amorphe.

Il a été montré qu'une structure de grille comportant une couche de Si₁₋ₓGeₓ est une alternative intéressante pour la technologie CMOS.

En effet, le matériau Si₁₋ₓGeₓ en plus d'avoir pour un dopage égal, une résistance plus faible que le silicium polycristallin, offre la possibilité de décaler la tension de seuil du dispositif PMOS obtenu, en fonction de la teneur en germanium de la couche de Si₁₋ₓGeₓ polycristallin. Ainsi, il peut être utilisé comme matériau "mid gap" dans une structure de grille P+ à la place de la structure traditionnelle P+/N+, c'est-à-dire, par exemple, pour des transistors à canaux N et P avec une grille simple comportant une couche de Si₁₋ₓGeₓ polycristallin de conductivité P+.

De plus, une grille à très forte concentration de germanium (≥ 75%) ou en germanium pur présente en plus l'avantage d'être compatible à la fois pour des transistors des deux types (N et P) ce qui conduit donc à un gain en étapes technologiques (suppression d'au moins deux étapes de photo-lithographie et, si la couche est dopée in-situ, de deux étapes d'implantation).

Le dépôt de couches de Si₁₋ₓGeₓ sur une couche d'oxyde de silicium a déjà été effectué par dépôt chimique en phase vapeur à basse pression (LPCVD) dans des fours multiplaques. Ce procédé nécessite le pré-dépôt d'une couche d'accrochage en silicium pur sur laquelle on effectue le dépôt de la couche de Si₁₋ₓGeₓ polycristallin. Cette couche d'accrochage permet d'obtenir une taille de grain acceptable dans la couche de Si₁₋ₓGeₓ, car elle empêche la tendance du germanium à se mettre en boule comme dans le cas d'un dépôt direct de Si₁₋ₓGeₓ sur une couche d'oxyde de silicium, ce qui, en fonction de la durée et de la température de dépôt, résulte en une croissance accélérée des grains au détriment de la nucléation.

Les utilisations de procédés de dépôt LPCVD comme indiqué précédemment, sont décrits dans les articles "Symmetric CMOS in fully-depleted silicon-on-insulator using P+ polycristalline Si-Ge gâte electrodes (CMOS symétrique dans un isolant sur silicium entièrement épuisé utilisant des électrodes de grille en Si-Ge polycristallin P+)" Neal KISTLER et Jason WOO, IEDM 93, p. 727-730, et "A polycrystalline-Si1-xGex-GATE CMOS TECHNOLOGY (Technologie CMOS à grille en Si1-xGex polycristallin)" T. KING et al., IEDM 90, p. 253-256.

Ces procédés de l'art antérieur présentent plusieurs inconvénients.

L'utilisation de techniques multiplaques "discontinues" s'avère peu pratique car il faut tenir compte des masses thermiques des lots de plaques, par exemple des plaques de 200 mm, des temps de purge et de stabilisation en température, ainsi que de la basse pression de travail qu'exigent les réacteurs.

D'autre part, l'inertie thermique de ces réacteurs multiplaques qui rend difficile les variations importantes nécessaires de la température, ne permet pas un dépôt optimum de la couche d'accrochage, de la couche de Si₁₋ₓGeₓ et éventuellement d'une couche de silicium protectrice.

Par ailleurs, on ne connaît pas aujourd'hui de procédé permettant d'enchaîner toutes les étapes conduisant à l'obtention complète du transistor, en raison notamment des difficultés de gravure de la grille de ce dernier.

L'invention propose donc un procédé d'obtention d'un transistor à effet de champ à grille isolée Si₁₋ₓGeₓ, où 0 < x ≤ 1, à partir d'un substrat semiconducteur comportant une zone dite active surmontée d'une couche d'oxyde de grille, ce procédé comprenant :
- une première phase de traitements à l'intérieur d'un réacteur monoplaque, comportant un dépôt sur la couche d'oxyde de grille d'une couche d'accrochage de silicium d'une épaisseur inférieure ou égale à 2 nm en utilisant un dépôt chimique en phase vapeur (CVD) à une température inférieure ou égale à 580°C, et un dépôt sur la couche d'accrochage d'un empilement comportant une première couche continue formée de Si₁₋ₓGeₓ, obtenue à partir d'un dépôt chimique en phase vapeur (CVD) à une température inférieure ou égale à 550°C, surmontée d'une deuxième couche de silicium, puis
- une phase d'élaboration de la grille du transistor, comportant un dépôt sur ledit empilement d'une couche supérieure constituée d'un matériau inorganique, une première gravure de ladite couche supérieure de façon à obtenir un masque inorganique surmontant ledit empilement, une deuxième gravure dudit empilement en utilisant ledit masque, de façon à former la région de grille, et un dépôt sur la région de grille d'une couche d'encapsulation formée d'un matériau non-oxydant vis-à-vis du germanium, puis
- une deuxième phase de traitements comportant la formation sur les flancs de la grille encapsulée de régions latérales isolantes formées d'un matériau non-oxydant vis-à-vis du germanium.

Les réacteurs monoplaques pour la mise en oeuvre du procédé selon l'invention, sont connus dans la technique et comprennent un dispositif central de chargement de plaques qui introduit une par une selon une séquence pré-établie, les plaques, par exemple des plaques de 200 mm de diamètre, dans des chambres de traitement réparties autour de ce dispositif central de chargement. Un tel type de reacteur est le modèle Centura HT^{®} commercialisé par la Société Applied Materials, ou le modèle Epsilon one^{®} commercialisé par la Société A.S.M.

L'utilisation d'un tel réacteur monoplaque permet de travailler à des pressions de l'ordre de 100 Pa à la pression atmosphérique, de varier rapidement la température de la plaque traitée pour mettre en oeuvre les différentes étapes de dépôt à la température optimale pour chaque couche de l'empilement et le tout dans un temps compatible avec les exigences d'une production industrielle.

Les variations rapides et contrôlées de la température permettent la croissance de couches uniformes en épaisseur et composition en un temps court, ce qui limite les effets de croissance des grains et donc la rugosité.

Le dépôt de la couche d'accrochage s'effectue avantageusement à une température comprise entre 500 et 580°C tandis que le dépôt de la première couche continue formée de Si₁₋ₓGeₓ s'effectue à une température comprise entre 400 et 500°C.

La couche d'accrochage a avantageusement une épaisseur inférieure ou égale à 1 nm et de préférence de l'ordre 0,5 nm. Par conséquence, la durée de dépôt doit être déterminée en fonction des autres conditions de dépôt pour s'assurer que l'épaisseur de la couche d'accrochage ait la valeur désirée.

La réalisation d'une telle couche d'accrochage d'épaisseur inférieure ou égale à 1 nm permet d'obtenir un dépôt d'une couche de Si₁₋ₓGeₓ ayant une granulométrie minimale, de l'ordre de 20 nm dans le cas le plus défavorable pour un dépôt de 100 nm, sans affecter les propriétés électriques (décalage de la tension de seuil Vₜ).

On utilise avantageusement un mélange de silane et d'hydrogène (SiH₄/H₂) pour le dépôt de la couche d'accrochage. Les débits de gaz utilisés sont généralement de 400 cm³/mn dans les conditions standards pour le silane et de préférence 20 à 30 litres par minute dans les conditions standards pour l'hydrogène. La pression totale de dépôt est atmosphérique.

Le mélange gazeux généralement utilisé pour le dépôt de la première couche continue de Si₁₋ₓGₓ est formé à partir d'un mélange de silane, germane et hydrogène (SiH₄GeH₄/H₂).

Les proportions des différents gaz du mélange varient en fonction des teneurs en germanium et silicium souhaitées pour la couche de Si₁₋ₓGeₓ et peuvent être aisément déterminées par l'homme du métier en fonction de la composition voulue pour la couche de Si₁₋ₓGeₓ.

Le dépôt s'effectue à une température comprise entre 400 et 550°C, et de préférence à 450°C, quelle que soit la valeur de x comprise entre 0,5 et 1 inclus.

La pression de dépôt est atmosphérique.

La durée du dépôt est fonction des conditions de température et de pression, des proportions des différents gaz dans le mélange gazeux et de l'épaisseur voulue pour la couche de Si₁₋ₓGeₓ polycristallin. Généralement, l'épaisseur de la couche de Si₁₋ₓGeₓ polycristallin sera comprise entre 50 nm et 200 nm, de préférence entre 100 et 150 nm, et mieux entre 80 et 150 nm. L'épaisseur de la deuxième couche de Si polycristallin ou amorphe est de l'ordre de 50 nm à 150 nm.

La première phase de traitements du procédé selon l'invention comporte avantageusement un dopage de l'empilement, et en particulier de la couche de Si₁₋ₓGeₓ, par exemple avec des atomes de bore ou de phosphore. Ce dopage peut s'effectuer par implantation après formation des différentes couches de l'empilement.

En variante, le dopage de l'empilement peut s'effectuer in situ. Dans ce cas, le dopage de l'empilement comporte avantageusement l'introduction d'un élément dopant dans le mélange gazeux utilisé pour le dépôt de la première couche continue formée de Si₁₋ₓGeₓ, après le dépôt d'une sous-couche de Si₁₋ₓGeₓ non dopée.

Plus précisément, on peut ajouter au mélange de gaz utilisé pour le dépôt un composé gazeux de l'élément dopant voulu, par exemple B₂H₆ ou PH₃. La proportion de composé gazeux de l'élément dopant dans le mélange gazeux sera fonction de la teneur voulue en élément dopant dans la couche déposée. Généralement, les niveaux de dopage sont égaux ou supérieurs à 10¹⁷cm⁻³ et de préférence de l'ordre de 10²⁰ cm⁻³.

Le pré-dépôt d'une couche de Si₁₋ₓGeₓ non dopé avant de déposer la couche de Si₁₋ₓGeₓ dopé, est recommandé pour éviter la diffusion du dopant à travers la mince couche d'oxyde de grille formée de SiO₂. Ce pré-dépôt, d'une épaisseur suffisante pour la protection de cette oxyde de grille, s'effectue comme décrit précédemment pour le dépôt de la couche Si₁₋ₓGeₓ.

Dans la phase d'élaboration de la grille du transistor, la première gravure s'effectue avantageusement au moyen d'un plasma haute densité d'un mélange de gaz constitué de Cl₂ et, soit de N₂ ou de NH3, soit d'un mélange N₂/NH3.

La deuxième gravure comporte une gravure principale avantageusement arrêtée avant d'atteindre l'oxyde de grille, et de préférence 30 à 40 nm avant d'atteindre l'oxyde de grille.

La deuxième gravure comporte, de préférence, après la gravure principale, une surgravure au moyen d'un plasma gazeux haute densité d'un mélange de gaz constitué de Cl₂ et de N₂ ou NH3, ou d'un mélange de ceux-ci, et éventuellement de O₂.

Toujours dans la phase de l'élaboration de la grille du transistor, le dépôt de la couche d'encapsulation s'effectue avantageusement sur la région de grille surmontée, au moins en partie, du masque inorganique, le dépôt de cette couche d'encapsulation pouvant également s'effectuer sur la région de grille complètement débarassée du masque inorganique, si possible.

Ce masque inorganique est par exemple formé d'une couche de SiO₂, éventuellement surmontée d'une couche de SiON.

La couche de SiO₂ ou de SiON formant la couche d'encapsulation est avantageusement déposée par un plasma gazeux de type CVD. L'épaisseur de cette couche d'encapsulation est avantageusement comprise entre 5 et 10 nm.

La deuxième phase de traitements du procédé selon l'invention prévoit avantageusement la formation des régions latérales isolantes à partir d'un plasma gazeux basse température (dépôt de SiO₂) ou bien à partir de Si₃N4.

D'autres avantages et caractéristiques de l'invention apparaîtront à l'examen de la description détaillée d'un mode de mise en oeuvre nullement limitatif et des dessins annexés sur lesquels :

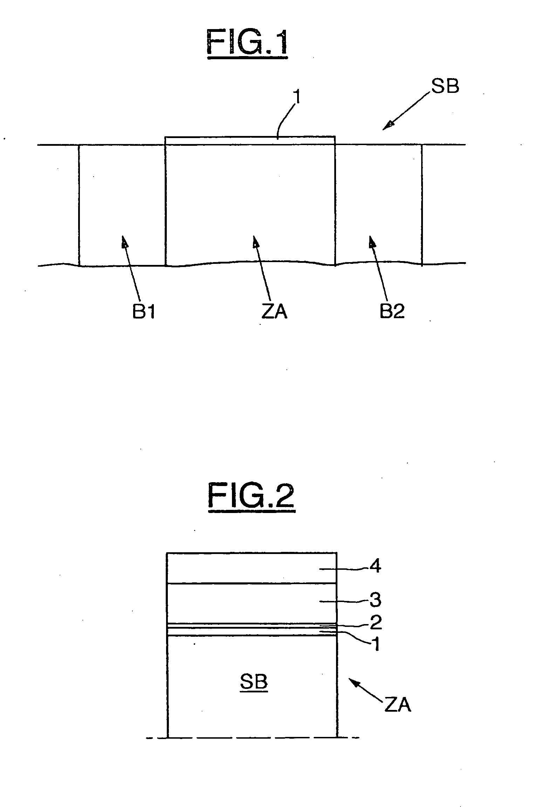

- les figures 1 à 8 illustrent très schématiquement les principales étapes d'un mode de mise en oeuvre du procédé selon l'invention.

Sur la figure 1, la référence SB désigne de façon générale un substrat semiconducteur, par exemple du silicium, dans lequel a été ménagée une zone active ZA pour l'implantation du futur transistor, zone active isolée latéralement dans cet exemple par des zones d'oxyde isolantes B1 et B2 ménagées dans des tranchées peu profondes (procédé Box). Bien entendu, d'autres modes d'isolation latérale sont possibles, notamment des zones d'isolation latérale du type LOCOS, bien connu de l'homme du métier.

La zone active ZA présente une surface de silicium à nu ou recouverte d'un oxyde chimique de protection.

Ensuite, une couche 1 d'oxyde de silicium SiO_{2,} servant de couche d'oxyde de grille, et ayant typiquement une épaisseur ≤ 5 nm, est réalisée.

Plus précisément, cette couche d'oxyde de grille peut être fabriquée dans un réacteur classique d'oxydation sèche ou humide avant l'introduction de la plaque dans le réacteur monoplaque en vue du dépôt notamment de la couche de Si₁₋ₓGeₓ.

Dans les autres figures, et à des fins de simplification, on ne représentera désormais que la zone active ZA du substrat.

La première étape du procédé de l'invention (figure 2) consiste à déposer sur la couche 1 d'oxyde de silicium, dans le réacteur monoplaque, une couche d'accrochage 2 en silicium d'épaisseur ≤ 1 nm, de préférence d'environ 0,5 nm, en utilisant un mélange gazeux à une température inférieure à 580°C. En ce qui concerne les mélanges gazeux utilisables pour le dépôt CVD, on utilise ici un mélange de silane et d'hydrogène (SiH₄/H₂). Les débits de gaz utilisés sont de préférence 400 cm³ par minute pendant 30 secondes dans les conditions standards pour le silane et de préférence 20 à 30 litres par minute dans les conditions standards pour l'hydrogène.

La température de dépôt de la couche d'accrochage est comprise entre 500 et 580°C, de préférence 550°C.

La pression de dépôt est généralement atmosphérique.

Une caractéristique importante de cette étape de dépôt de la couche d'accrochage en silicium est que l'épaisseur de la couche d'accrochage finale soit ≤ 1 nm de préférence de l'ordre de 0,5 nm. Par conséquent, la durée de cette étape de dépôt doit être déterminée en fonction des autres conditions de dépôt pour s'assurer que l'épaisseur de la couche d'accrochage soit inférieure ou égale à 1 nm.

La réalisation d'une telle couche d'accrochage d'épaisseur inférieure ou égale à 1 nm, permet d'obtenir un dépôt d'une couche de Si₁₋ₓGeₓ polycristallin ayant une granulométrie minimale, de l'ordre de 20 nm dans le cas le plus défavorable d'une couche de Ge pur de 100 nm, sans affecter les propriétés électriques (décalage de la tension de seuil Vₜ).

La deuxième étape du procédé selon l'invention est le dépôt d'une couche 3 de Si₁₋ₓGeₓ où 0 < x ≤ 1. De préférence, x est compris entre 0,05 et 1, de préférence encore entre 0,25 et 1, et mieux entre 0,50 et 1. Le mélange gazeux généralement utilisé pour le dépôt CVD est un mélange de silane, germane et hydrogène (SiH₄/GeH₄/H₂).

Les proportions des différents gaz du mélange varient en fonction des teneurs en germanium et silicium souhaitées pour la couche de Si₁₋ₓGeₓ et peuvent être aisément déterminées par l'homme du métier en fonction de la composition voulue pour la couche de Si₁₋ₓGeₓ.

Le dépôt s'effectue à une température comprise entre 400 et 550°C, et de préférence entre 450 et 550°C. Plus la teneur en germanium du mélange gazeux est élevée, plus basse doit être la température de dépôt. Ainsi, pour le dépôt d'une couche de germanium pur, la température de dépôt sera comprise entre 400 et 450°C.

La pression totale de dépôt est généralement atmosphérique.

La durée du dépôt est fonction des conditions de température et de pression, des proportions des différents gaz dans le mélange gazeux et de l'épaisseur voulue pour la couche de Si₁₋ₓGeₓ polycristallin. Généralement, l'épaisseur de la couche de Si₁₋ₓGeₓ polycristallin sera comprise entre 50 nm et 200 nm, de préférence entre 100 et 150 nm, et mieux entre 80 et 150 nm.

On dépose ensuite sur la couche 3 de silicium-germanium une deuxième couche de silicium 4 (ou couche d'encapsulation) en utilisant un mélange gazeux, par exemple un mélange de silane et d'hydrogène. Cette couche a généralement une épaisseur de 50 à 200 nm, et de préférence de 50 à 100 nm.

On a ainsi réalisé à titre d'exemple, dans un réacteur monoplaque, le dépôt d'une couche de Si₁₋ₓGeₓ où x = 0,55 sur une couche d'oxyde de silicium d'une plaquette pour une filière CMOS à canal ≤ 0,18 µm, avec les conditions indiquées ci-dessous :
**a.** Dépôt d'une couche d'accrochage en silicium.
   - Stabilisation de la température à 550°C.
   - Dépôt au moyen d'un mélange gazeux SiH₄/H₂ d'une couche de silicium d'épaisseur inférieure à 0,5 nm (mesurée par cinétique de croissance et estimée par ellipsométrie).
      SiH₄ 400 cm³/min standard
      H₂ 20 l/min standard
      Température : 550°C
      Pression : atmosphérique
      Durée du dépôt : 30 secondes.
**b.** Dépôt d'une couche de Si₁₋ₓGeₓ polycristallin, x = 0,55, d'une épaisseur de 60 nm.
   - Stabilisation de la température à 450°C.
   - Dépôt de la couche de Si₁₋ₓGeₓ au moyen d'un plasma gazeux SiH₄/GeH₄/H₂.
      SiH₄ 70 cm³/min standard
      GeH₄ (10% dans H₂) 300 cm³/min standard
      H₂ 30 l/min standard
      Température : 450°C
      Pression : atmosphérique
      Durée du dépôt : 70 secondes.
**c.** Dépôt d'une couche d'encapsulation de silicium d'une épaisseur de 140 nm.
   - Stabilisation de la température à 600°C.
   - Dépôt de la couche de silicium au moyen d'un plasma gazeux. SiH₄ 300 cm³/min standard
      H₂ 30 l/min standard
      Température : 600°C
      Pression : atmosphérique
      Durée du dépôt : 270 secondes.

On a également réalisé à titre d'exemple, dans un réacteur monoplaque, le dépôt d'une couche de Si₁₋ₓGeₓ où x = 1 (Ge pur) sur une couche d'oxyde de silicium d'une plaquette pour une filière CMOS à canal ≤ 0,18 µm, avec les conditions indiquées ci-dessous :
a. Dépôt d'une couche d'accrochage en silicium.
   - Stabilisation de la température à 550°C.
   - Dépôt au moyen d'un mélange gazeux SiH₄/H₂ d'une couche de silicium d'épaisseur inférieure à 0,5 nm (mesurée par cinétique de croissance et estimée par ellipsométrie).
      SiH₄ 400 cm³/min standard
      H₂ 20 l/min standard
      Température : 550°C
      Pression : atmosphérique
      Durée du dépôt : 30 secondes.
**b.** Dépôt d'une couche de Si₁₋ₓGeₓ polycristallin, x = 1, d'une épaisseur de 60 nm.
   - Stabilisation de la température à 450°C.
   - Dépôt de la couche de Ge au moyen d'un plasma gazeux GeH₄/H₂.
      GeH₄ (10% dans H₂) 300 cm³/min standard
      H₂ 30 l/min standard
      Température : 450°C
      Pression : atmosphérique
      Durée du dépôt : 45 secondes.
**c.** Dépôt d'une couche d'encapsulation de silicium d'une épaisseur de 140 nm.
   - Stabilisation de la température à 600°C.
   - Dépôt de la couche de silicium au moyen d'un plasma gazeux.
      SiH₄ 300 cm³/min standard
      H₂ 30 l/min standard
      Température : 600°C
      Pression : atmosphérique
      Durée du dépôt : 270 secondes.

La première phase de traitements comportant la réalisation de l'empilement Si, Si/Ge et Si, dans un four monoplaque permet de parfaitement maîtriser la nucléation du SiGe sur l'oxyde de grille, de contrôler l'uniformité d'épaisseur et de concentration en germanium sur la plaque et de réaliser un système bicouche SiGe/Si polycristallin sans remise à l'air de la plaque entre les deux couches.

On ne retrouve pas ces avantages dans un four multiplaques, notamment à cause des temps trop longs de dépôt, occasionnant une croissance du germanium dont les grains vont également grossir avec au moins deux effets négatifs qui sont une augmentation de la rugosité et une possible non-continuïté et uniformité des dépôts. En outre, dans un four multiplaques il est difficile d'obtenir des dépôts uniformes en composition à cause de l'effet d'appauvrissement (notamment dans les concentrations en germanium supérieures à 50%).

Le dépôt monoplaque permet de contrôler des concentrations de germanium de 0 à 100% et notamment les dépôts particulièrement utiles dans lesquels la concentration est supérieure à 50%.

En outre, la réalisation d'un système bicouche dans lequel la couche de silicium-germanium est surmontée (encapsulée) par une couche de silicium, permet de se rapprocher pour la suite des étapes technologiques, des procédés classiques d'intégration, c'est-à-dire les procédés "tout silicium".

En effet, pour des concentrations en germanium inférieures à 100%, la grille doit être compatible CMOS, c'est-à-dire implantée localement N ou P, suivant le type de transistor à réaliser. Ces implantations locales sont réalisées à travers un masque de résine organique ce qui implique un retrait ultérieur de celle-ci. C'est justement le retrait de cette résine, et le nettoyage de surface approprié qui imposent que la grille en silicium-germanium soit encapsulée sous une couche de silicium afin de ne pas modifier, voire supprimer, la couche de silicium-germanium lors des retraits de résine.

Les épaisseurs de la couche de silicium-germanium (ou de germanium) et de silicium d'encapsulation résultent d'un compromis entre la croissance des grains du silicium/germanium ou germanium (de façon à éviter la nucléation hétérogène) et celle du silicium polycristallin d'encapsulation qui prend appui sur ces grains. D'autre part, pour des contraintes électriques, la couche de silicium/germanium doit être la plus continue possible, c'est-à-dire la moins rugueuse possible. Cette couche de silicium germanium doit donc être suffisamment épaisse mais pas trop. L'épaisseur totale de la grille ainsi formée est par exemple de 200 nm pour une technologie 0,18 µm. Elle sera plus faible pour des technologies inférieures à 0,18 µm, typiquement de l'ordre de 100 à 150 nm. Le compromis actuel est une couche de SiGe de 120 nm d'épaisseur et une couche de silicium d'encapsulation de 80 nm d'épaisseur, pour une technologie 0,18 µm.

L'étape suivante du procédé selon l'invention consiste en un dopage de l'empilement formé à la figure 2. Il est à noter ici que, pour une grille en germanium pur ou ayant une concentration en germanium supérieure à 75%, la grille sera dopée de type P quel que soit le type de transistor, et ce pour des raisons théoriques. D'une façon générale, le dopage de la grille se fait soit par une implantation ionique pleine plaque, soit in-situ lors du dépôt proprement dit de l'empilement dans le réacteur monoplaque à l'aide de mélanges gazeux.

On peut ainsi obtenir un dépôt direct d'une couche de Si₁₋ₓGeₓ polycristallin dopée, par exemple avec du bore ou du phosphore, en ajoutant au mélange de gaz utilisé pour le dépôt un composé gazeux de l'élément dopant voulu, par exemple B₂H₆ ou PH₃. La proportion de composé gazeux de l'élément dopant dans le mélange gazeux sera fonction de la teneur voulue en élément dopant dans la couche déposée. Généralement, les niveaux de dopage sont égaux ou supérieurs à 10¹⁷ cm⁻³ et de préférence de l'ordre de 10²⁰ cm⁻³.

Dans le cas du dépôt direct d'une couche de Si₁₋ₓGeₓ dopé, il est recommandé pour éviter la diffusion des dopants dans la mince couche de SiO₂ (oxyde de grille), d'effectuer un pré-dépôt d'une couche de Si₁₋ₓGeₓ non dopé avant de déposer la couche de Si₁₋ₓGeₓ dopé. Ce pré-dépôt, d'une épaisseur suffisante pour la protection de l'oxyde de grille sous-jacent, s'effectue comme décrit précédemment pour le dépôt de la couche Si₁₋ₓGeₓ. Une fois le pré-dépôt effectué, on ajoute au mélange gazeux le composé gazeux de l'élément dopant pour effectuer le dépôt de la couche de Si₁₋ₓGeₓ dopé comme indiqué ci-dessus.

Le dépôt de la couche 4 de silicium d'encapsulation qui peut être également dopée, s'effectue de préférence dans le réacteur monoplaque en utilisant un mélange gazeux classique, par exemple un mélange de silane et hydrogène, éventuellement contenant un composé gazeux de l'élément dopant tel que B₂H₆ et PH₃, dans les conditions classiques.

Dans la technologie silicium traditionnelle, la gravure de la grille se fait après une étape de photo-lithographie d'une résine organique traditionnelle.

Malheureusement, les procédés de gravure par plasma haute densité utilisés classiquement pour la gravure de silicium ne conviennent pas pour la gravure d'une couche de Si₁₋ₓGeₓ ou d'un empilement Si₁₋ₓGeₓ/Si, en particulier lorsque la teneur en germanium de la couche de poly Si₁₋ₓGeₓ est supérieure à 50% (x ≥ 0,5). En effet, les procédés de gravure par plasma classiques conduisent à des déformations des profils des motifs gravés, en particulier des flancs de ceux-ci.

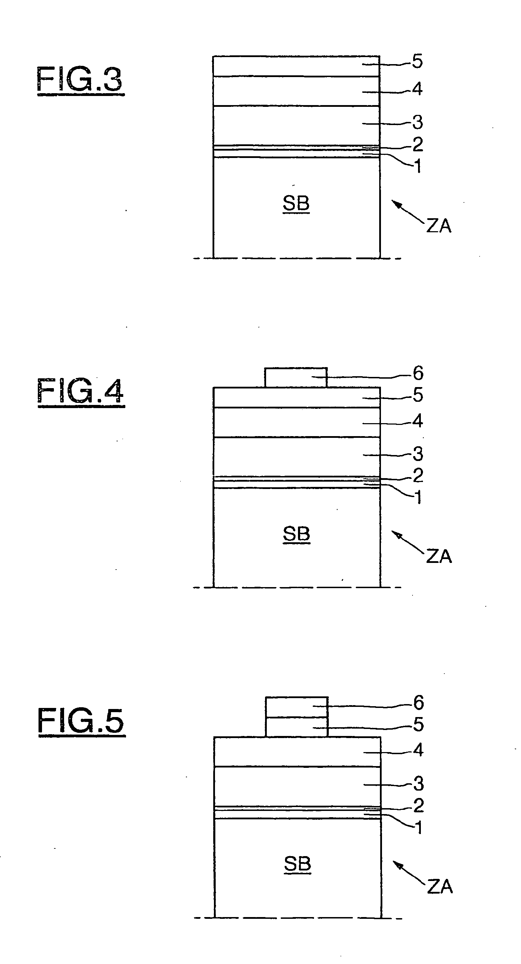

La gravure selon l'invention débute par la formation (figure 3) d'un masque 5 en matériau inorganique, qui comprend le dépôt, par un procédé classique tel qu'un dépôt en phase vapeur à basse pression, d'un matériau inorganique, par exemple une couche de SiO₂ ou une double couche de SiO₂/SiON.

Après formation (figure 4) sur cette couche 5 de matériau inorganique d'un masque 6 de résine classique, par exemple par photolithogravure, le masque 5 en matériau inorganique est gravé (figure 5), de préférence par gravure par plasma haute densité, et de préférence encore en utilisant un mélange gazeux de chlore et d'azote et/ou ammoniac.

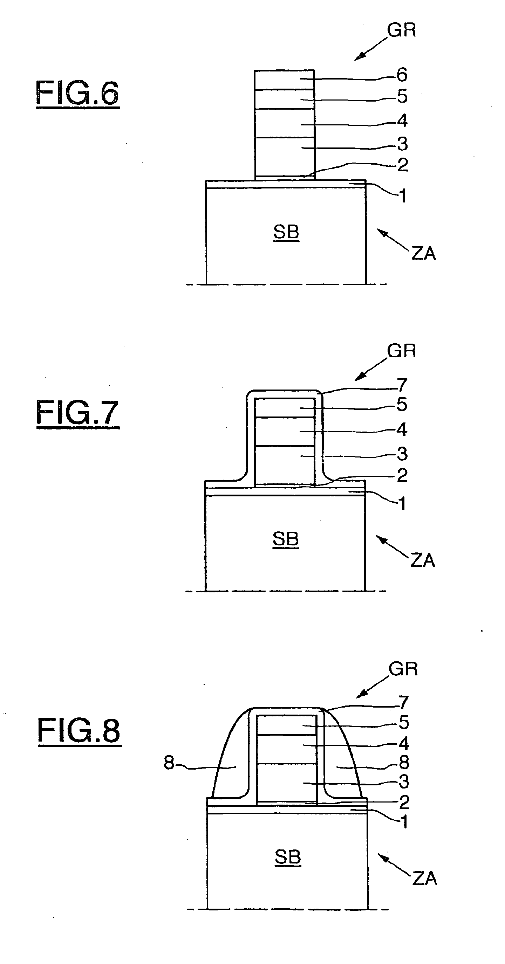

Une caractéristique essentielle de la gravure de la grille GR selon l'invention (figure 6) consiste en une étape de gravure principale, anisotrope, au moyen d'un plasma gazeux haute densité à base de chlore, exempte d'oxygène et de HBr, et incluant N₂ ou NH₃ ou leur mélange pour réaliser une couche de passivation des flancs de gravure par co-adsorption avec le chlore atomique afin de réduire la vitesse latérale de gravure spontanée par le chlore. Cette addition de N₂ ou NH₃ ou d'un mélange de ces composés entraîne peu ou pas de résidu de gravure, et ne provoque pas d'érosion latérale ou d'altération de la couche de Si₁₋ₓGeₓ ou de l'oxyde de grille sous-jacent. En outre, l'utilisation d'un tel mélange gazeux est compatible avec des mises en oeuvre industrielles du procédé de gravure.

Les proportions de N₂ et/ou NH₃ introduites dans le mélange gazeux du plasma peuvent être déterminées expérimentalement, de manière classique, et doivent être suffisantes pour bloquer les cinétiques des réactions chimiques spontanées responsables de la gravure latérale des flancs des motifs gravés non soumis au bombardement ionique, sans pour autant bloquer les cinétiques des réactions induites par le bombardement ionique responsable de la gravure verticale.

De préférence, dans le procédé de la présente invention, l'étape de gravure principale est suivie d'une étape de surgravure dans laquelle l'énergie des ions du plasma est réduite par rapport à l'étape de gravure principale. Lors de cette étape de surgravure, on peut utiliser le même mélange gazeux que dans l'étape de gravure principale, mais on peut également utiliser des mélanges gazeux contenant de l'oxygène, car la couche de passivation formée par les flancs du motif gravé au cours de l'étape de gravure principale avec le mélange gazeux exempt d'oxygène et de HBr protège les flancs du motif gravé d'une gravure spontanée par les atomes d'oxygène pendant cette étape de surgravure.

La quantité d'oxygène peut être déterminée expérimentalement pour accroître la sélectivité Si₁₋ₓGeₓ/oxyde de grille sans entraîner une gravure latérale spontanée des motifs gravés.

De préférence encore, l'étape de gravure principale est arrêtée avant d'atteindre la couche 1 d'oxyde de silicium sous-jacente, de préférence à une distance comprise entre 30 et 40 nm de l'oxyde de silicium 1. On évite ainsi tout risque de dégradation de l'oxyde de grille pendant l'étape de gravure principale.

On reprend à l'exemple évoqué ci-avant, dans lequel on forme sur une couche 1 d'oxyde de silicium d'un substrat et sur une couche d'accrochage 2, un empilement d'une première couche 3 de Si_{0,45}Ge_{0,55} polycristallin (120 nm d'épaisseur) et d'une seconde couche 4 de silicium polycristallin (80 nm d'épaisseur). Sur la seconde couche 4 de silicium polycristallin, on dépose une couche de masquage 5 en un matériau inorganique, par exemple une couche d'oxyde de silicium.

Après formation d'un masque 6 de résine sur la couche de masquage en matériau inorganique, on effectue la gravure de la couche de masquage et de l'empilement dans les conditions indiquées dans le tableau I ci-dessous.

**TABLEAU I**

| | Plasma | | | Durée du traitement(s) |
|---|---|---|---|---|
| | | | | |
| | Mélange de gaz Puissance de Puisance de polarisation la source (W) appliquée au porte-substrat (W) | | | |
| | | | | |
| Percement du masque en matériau inorganique | HBr/Cl₂/O₂ (40/40//8) | 2500 | 400 | 5 |
| | | | | |
| Etape de gravure principale | HBr/Cl₂/O₂ (40/40/8) | 2500 | 150 | 52 |

| | | | | |
|---|---|---|---|---|
| * Dans les exemples, sauf indication contraire, tous les débits de gaz sont exprimés en cm³/minute dans les conditions standards. | | | | |

On observe une forte déformation du profil de gravure des motifs dans les flancs de la couche de Si_{0,45}Ge_{0,55} polycristallin. Une analyse par spectroscopie de photoélectrons X de l'épaisseur de la couche d'oxyde qui passive les flancs des motifs gravés, montre que celle-ci a une épaisseur de 1 nm sur les flancs de la couche de Si_{0,45}Ge_{0,55} polycristallin contre 3 nm sur les flancs de la couche de silicium polycristallin.

Comme dans le cas du silicium polycristallin, la couche de passivation des flancs de Si_{0,45}Ge_{0,55} est un oxyde de silicium sous stoechiométrique fortement chloré. La couche de passivation ne se forme donc qu'à partir des produits de réaction de gravure du silicium, ce qui explique que son épaisseur sur le flanc du motif gravé diminue pour la couche de Si_{0,45}Ge_{0,55}.

Après cette phase de gravure de la grille GR (figure 6), on procède à un retrait des résidus de gravure et éventuellement, si possible, un retrait du masque dur 5. Cette étape consiste en une désoxydation dans un bain de HF faiblement concentrée, (≤ 1%). Typiquement, cette étape correspond à la gravure de 10 Å d'oxyde thermique sur pleine plaque. Elle sert principalement à dissoudre tous les résidus de polymères qui auraient pu être générés lors de la gravure de la grille.

Dans le cas d'un masque dur composé d'une couche d'oxyde de silicium surmontée d'une couche de SiON, la couche de SiON a été consommée lors de l'étape de gravure de la grille proprement dite. Dans ce cas, on se retrouve dans la même configuration que dans le cas d'un masque dur composé uniquement de SiO₂.

Il est possible, mais non indispensable, de retirer également dans cette étape la totalité du masque dur 5, si le temps de retrait est compatible avec la technologie utilisée. C'est notamment le cas avec un masque dur de 60 nm de SiO₂ dans une technologie 0,18 µ. En effet, le temps de retrait du masque dur dans un bain d'acide fluorhydrique dilué est typiquement égal au temps de gravure d'un oxyde thermique de 60 Å.

Dans la suite du texte, on supposera néanmoins, comme illustré notamment sur la figure 7, que le masque dur 5 n'a pas été totalement retiré. L'étape suivante (figure 7) consiste en une encapsulation de la grille GR par un matériau 7 non-oxydant vis-à-vis du germanium, typiquement une couche d'oxyde de silicium SiO₂ ou SiON. Cette étape d'encapsulation de la grille est indispensable pour protéger des flancs de la grille lors des étapes technologiques suivantes, qui consistent notamment en la réalisation des implantations des régions de drain et de source demandant des étapes de photo-lithographie, qui, en raison de la nécessité du retrait d'une résine organique, endommageraient la couche de silicium/germanium.

On utilise pour la formation de cette couche d'oxyde de silicium d'encapsulation un dépôt par un plasma gazeux de type CVD. Le choix d'un oxyde plasma pour cette encapsulation est justifié par le fait que le germanium réagit très fortement avec l'oxygène. Il est donc nécessaire d'utiliser un procédé où l'oxygène atomique présente une durée de vie en phase gazeuse très courte, comme c'est le cas pour un oxyde formé par dépôt chimique en phase vapeur assisté par plasma (dépôt PECVD) basse température.

L'épaisseur typique de cette couche d'encapsulation 7 est comprise entre 5 et 10 nm. Cette faible épaisseur est justifiée pour ne pas trop s'éloigner des technologies au silicium traditionnelles qui utilisent un oxyde thermique d'épaisseur variant entre 2,5 et 5 nm. D'autre part, cette faible épaisseur permet de contrôler la profondeur des différentes implantations sans altérer les propriétés électriques intrinsèques des transistors.

On peut alors procéder sur ce transistor comportant la grille encapsulée GR, aux étapes classiques (non représentées à des fins de simplification) de photo-lithographie et d'implantation des régions de source et de drain (implantations LDD par exemple) pour la formation des régions latérales isolantes de la grille (espaceurs 8, figure 8). Le choix du matériau dépend du bilan thermique possible de la filière technologique. Ceci étant, du fait que l'oxyde d'encapsulation 7, protégeant les flancs de la grille GR, est poreux à l'oxygène, tout dépôt mettant en jeu l'oxygène à haute température est à exclure, comme en particulier une oxydation du silicium assisté par température (dépôt TEOS). Le matériau pour les espaceurs peut être en revanche soit un oxyde plasma obtenu à basse température (SiO₂), soit un nitrure de silicium Si₃N4. Les épaisseurs typiques des dépôts sont optimisées en fonction des contraintes des filières technologiques utilisées. Typiquement, il est possible de déposer une couche de SiO₂ de 250 nm d'épaisseur ou une couche de Si₃N4 de 100 nm d'épaisseur pour des espaceurs qui, après gravure, auront une largeur au pied de la grille de 0,1 à 0,13 µ.

La gravure d'espaceurs est une étape classique bien connue de l'homme du métier. Il convient de noter ici que, si lors de l'étape de retrait des résidus polymères après gravure de la grille, le retrait du masque dur 5, n'a pu être possible, son retrait peut être effectué maintenant soit lors de l'étape de gravure sèche des espaceurs, soit par une gravure chimique sélective vis-à-vis des espaceurs à la fin de cette étape.

## Revendications

1. Procédé d'obtention d'un transistor à effet de champ à grille isolée Si₁₋ₓGeₓ, où 0 < x ≤ 1, à partir d'un substrat semiconducteur (SB) comportant une zone dite active (ZA) surmontée d'une couche (1) d'oxyde de grille, comprenant:
- une première phase de traitements à l'intérieur d'un réacteur mono-plaque, comportant un dépôt sur la couche d'oxyde de grille (1) d'une couche d'accrochage de silicium (2) d'une épaisseur inférieure ou égale à 2 nm en utilisant un dépôt chimique en phase vapeur (CVD) à une température inférieure ou égale à 580°C, et un dépôt sur la couche d'accrochage d'un empilement comportant une première couche continue (3) formée de Si₁₋ₓGeₓ, obtenue à partir d'un dépôt chimique en phase vapeur (CVD) à une température inférieure ou égale à 550°C, surmontée d'une deuxième couche de silicium (4), puis
- une phase d'élaboration de la grille (GR) du transistor, comportant un dépôt sur ledit empilement d'une couche supérieure (5) constituée d'un matériau inorganique, une première gravure de ladite couche supérieure (5) de façon à obtenir un masque inorganique (5) surmontant ledit empilement, une deuxième gravure dudit empilement en utilisant ledit masque, de façon à former la région de grille (GR), et un dépôt sur la région de grille d'une couche d'encapsulation (7) formée d'un matériau non oxydant vis à vis du germanium, puis
- une deuxième phase de traitements comportant la formation sur les flancs de la grille encapsulée de régions latérales isolantes (8) formées d'un matériau non oxydant vis-à-vis du germanium.

2. Procédé selon la revendication 1, **caractérisé par le fait que** le dépôt de la couche d'accrochage (2) s'effectue à une température comprise entre 500 et 580 °C et le dépôt de la première couche continue (3) formée de Si₁₋ₓGeₓ s'effectue à une tempérarture comprise entre 400 et 500°C.

3. Procédé selon la revendication 1 ou 2, **caractérisé par le fait que** la couche d'accrochage (2) a une épaisseur inférieure ou égale à 1 nm.

4. Procédé selon l'une des revendications précédentes, **caractérisé par le fait que** le mélange gazeux pour le dépôt de la couche d'accrochage (2) est formé à partir d'un mélange de silane et d'hydrogène, et le mélange gazeux pour le dépôt de la première couche continue (3) formée de Si₁₋ₓGeₓ est formé à partir d'un mélange de silane, germane et hydrogène.

5. Procédé selon l'une des revendications précédentes, **caractérisé par le fait que** la première phase de traitements comporte un dopage de l'empilement.

6. Procédé selon la revendication 5, **caractérisé par le fait que** le dopage de l'empilement comporte l'introduction d'un élément dopant dans le mélange gazeux utilisé pour le dépôt de la première couche continue (3) formée de Si₁₋ₓGeₓ après le dépôt d'une sous-couche de Si₁₋ₓGeₓ non dopé.

7. Procédé selon l'une des revendications précédentes, **caractérisé par le fait que** dans la phase d'élaboration de la grille (GR) du transistor, la première gravure s'effectue au moyen d'un plasma haute densité d'un mélange de gaz constitué de Cl₂, N₂ et/ou NH3.

8. Procédé selon l'une des revendications précédentes, **caractérisé par le fait que** dans la phase d'élaboration de la grille du transistor, la deuxième gravure comprend une gravure principale anisotrope et s'effectuant au moyen d'un plasma haute densité d'un mélange de gaz constitué de Cl₂ et, soit de N₂ ou de NH3, soit d'un mélange de N₂ et de NH3.

9. Procédé selon la revendication 8, **caractérisé par le fait que** la gravure principale est arrêtée avant d'atteindre l'oxyde de grille (1), et de préférence 30 à 40 nm avant d'atteindre l'oxyde de grille.

10. Procédé selon la revendication 8 ou 9, **caractérisé par le fait que** la deuxième gravure comporte, après la gravure principale, une surgravure au moyen d'un plasma gazeux haute densité d'un mélange de gaz constitué de Cl₂ et de N₂ ou NH3 ou d'un mélange de ceux-ci, et éventuellement de O₂.

11. Procédé selon l'une des revendications précédentes, **caractérisé par le fait que** le dépôt de la couche d'encapsulation (7) s'effectue sur la région de grille surmontée au moins en partie du masque inorganique (5).

12. Procédé selon l'une des revendications précédentes, **caractérisé par le fait que** le masque inorganique (5) est formé d'une couche de SiO₂, éventuellement surmontée d'une couche de SiON.

13. Procédé selon l'une des revendications précédentes, **caractérisé par le fait que** la couche d'encapsulation (7) est une couche de SiO₂ ou de SiON déposée par plasma gazeux de type CVD.

14. Procédé selon la revendication 13, **caractérisé par le fait que** l'épaisseur de la couche d'encapsulation est comprise entre 5 et 10 nm.

15. Procédé selon l'une des revendications précédentes, **caractérisé par le fait que** les régions latérales isolantes (8) sont formées de SiO₂ déposé par plasma gazeux basse température, ou de Si₃N₄.

16. Procédé selon l'une des revendications précédentes, **caractérisé par le fait que** la couche d'oxyde de grille (1) est déposée dans le réacteur mono-plaque.

17. Procédé selon l'une des revendications précédentes, **caractérisé par le fait que** x est compris entre 0,5 et 1.

18. Procédé selon l'une des revendications précédentes, **caractérisé par le fait que** l'épaisseur de la première couche continue (3) de Si₁₋ₓGeₓ est comprise entre 50 et 200 nm, et l'épaisseur de la deuxième couche de silicium (4) est comprise entre 50 et 200 nm.

## Claims

1. Method of obtaining an Si₁₋ₓGeₓ, where 0 < x ≤ 1, insulated gate field-effect transistor from a semiconductor substrate (SB) including an area called the active area (ZA) surmounted by a gate oxide layer (1), comprising:
- a first phase of processing inside a single-plate reactor, including a deposition on the gate oxide layer (1) of a silicon attachment layer (2) of a thickness less than or equal to 2 nm using a chemical vapour phase deposition (CVD) at a temperature less than or equal to 580°C, and a deposition on the attachment layer of a stack including a continuous first layer (3) formed of Si₁₋ₓGeₓ, obtained from a chemical vapour phase deposition (CVD) at a temperature less than or equal to 550°C, surmounted by a second silicon layer (4), then
- a phase of production of the gate (GR) of the transistor, including a deposition on said stack of an upper layer (5) consisting of an inorganic material, a first etching of said upper layer (5) to obtain an inorganic mask (5) surmounting said stack, a second etching of said stack using said mask, in such a manner as to form the gate region (GR), and a deposition on the gate region of an encapsulation layer (7) formed of a material that is non-oxidizing vis à vis the germanium, then
- a second phase of processing including the formation on the flanks of the encapsulated gate of insulative lateral regions (8) formed of a material that is non-oxidizing vis à vis the germanium.

2. Method according to Claim 1, **characterized in that** the deposition of the attachment layer (2) is effected at a temperature between 500 and 580°C and the deposition of the continuous first layer (3) formed of Si₁₋ₓGeₓ is effected at a temperature between 400 and 500°C.

3. Method according to Claim 1 or 2, **characterized in that** the attachment layer (2) has a thickness less than or equal to 1 nm.

4. Method according to any one of the preceding claims, **characterized in that** the gaseous mixture for the deposition of the attachment layer (2) is formed from a mixture of silane and hydrogen, and the gaseous mixture for the deposition of the continuous first layer (3) formed of Si₁₋ₓGeₓ is formed from a mixture of silane, germane and hydrogen.

5. Method according to any one of the preceding claims, **characterized in that** the first phase of processing includes a doping of the stack.

6. Method according to Claim 5, **characterized in that** the doping of the stack includes the introduction of a doping element into the gaseous mixture used for the deposition of the continuous first layer (3) formed of Si₁₋ₓGeₓ after the deposition of a sublayer of undoped Si₁₋ₓGeₓ.

7. Method according to any one of the preceding claims, **characterized in that** in the phase of producing the gate (GR) of the transistor, the first etching is effected by means of a high-density plasma of a gas mixture consisting of Cl₂, N₂ and/or NH₃.

8. Method according to any one of the preceding claims, **characterized in that** in the phase of production of the gate of the transistor, the second etching comprises a principal anisotropic etching and being effected by means of a high-density plasma of a gas mixture consisting of Cl₂ and, either N₂ or NH₃, or a mixture of N₂ and NH₃.

9. Method according to Claim 8, **characterized in that** the principal etching is stopped before reaching the gate oxide (1), and preferably 30 to 40 nm before reaching the gate oxide.

10. Method according to Claim 8 or 9, **characterized in that** the second etching includes, after the principal etching, an overetching by means of a high-density gaseous plasma of a gas mixture consisting of Cl₂ and N₂ or NH₃ or a mixture of the latter, and possibly O₂.

11. Method according to any one of the preceding claims, **characterized in that** the deposition of the encapsulation layer (7) is effected over the gate region surmounted at least in part by the inorganic mask (5).

12. Method according to any one of the preceding claims, **characterized in that** the inorganic mask (5) is formed of a layer of SiO₂, possibly surmounted by a layer of SiON.

13. Method according to any one of the preceding claims, **characterized in that** the encapsulation layer (7) is a layer of SiO₂ or of SiON deposited by CVD type gaseous plasma.

14. Method according to Claim 13, **characterized in that** the thickness of the encapsulation layer is between 5 and 10 nm.

15. Method according to any one of the preceding claims, **characterized in that** the insulative lateral regions (8) are formed of SiO₂ deposited by low-temperature gaseous plasma, or of Si₃N₄.

16. Method according to any one of the preceding claims, **characterized in that** the gate oxide layer (1) is deposited in the single-plate reactor.

17. Method according to any one of the preceding claims, **characterized in that** x is between 0.5 and 1.

18. Method according to any one of the preceding claims, **characterized in that** the thickness of the continuous first layer (3) of Si₁₋ₓGeₓ is between 50 and 200 nm, and the thickness of the silicon second layer (4) is between 50 and 200 nm.

## Patentansprüche

1. Verfahren zum Erhalt eines Si₁₋ₓGeₓ-Isolated-Gate-Feldeffekttransistors, wobei 0 < x ≤ 1, aus einem Halbleitersubstrat (SB) mit einer sogenannten aktiven Zone (ZA) mit einer darüber angeordneten Gateoxidschicht (1), umfassend:
- eine erste Phase von Behandlungen in einem Einwaferreaktor, umfassend eine Abscheidung einer Siliciumhaftschicht (2) mit einer Dicke kleiner gleich 2 nm auf der Gateoxidschicht (1) durch CVD bei einer Temperatur kleiner gleich 580°C und eine Abscheidung eines Stapels mit einer durch CVD bei einer Temperatur kleiner gleich 550°C erhaltenen ersten kontinuierlichen Schicht (3) aus Si₁₋ₓGeₓ mit einer darüber angeordneten zweiten Siliciumschicht (4) auf der Haftschicht, dann
- eine Phase der Bildung des Gate (GR) des Transistors, umfassend eine Abscheidung einer Deckschicht (5) aus einem anorganischen Material auf dem Stapel, ein erstes Ätzen der Deckschicht (5) zum Erhalt einer über dem Stapel angeordneten anorganischen Maske (5), ein zweites Ätzen des Stapels unter Verwendung der Maske zur Bildung des Gatebereichs (GR) und eine Abscheidung einer Verkapselungsschicht (7) aus einem gegenüber Germanium nichtoxidierenden Material auf dem Gatebereich, dann
- eine zweite Phase von Behandlungen, umfassend die Bildung von isolierenden Seitenbereichen (8) aus einem gegenüber Germanium nichtoxidierenden Material auf den Flanken des verkapselten Gate.

2. Verfahren nach Anspruch 1, **dadurch gekennzeichnet, daß** die Abscheidung der Haftschicht (2) bei einer Temperatur zwischen 500 und 580°C erfolgt und die Abscheidung der ersten kontinuierlichen Schicht (3) aus Si₁₋ₓGeₓ bei einer Temperatur zwischen 400 und 500°C erfolgt.

3. Verfahren nach Anspruch 1 oder 2, **dadurch gekennzeichnet, daß** die Haftschicht (2) eine Dicke kleiner gleich 1 nm aufweist.

4. Verfahren nach einem der vorhergehenden Ansprüche, **dadurch gekennzeichnet, daß** das Gasgemisch für die Abscheidung der Haftschicht (2) aus einem Gemisch von Silan und Wasserstoff gebildet wird und das Gasgemisch für die Abscheidung der ersten kontinuierlichen Schicht (3) aus Si₁₋ₓGeₓ aus einem Gemisch von Silan, German und Wasserstoff gebildet wird.

5. Verfahren nach einem der vorhergehenden Ansprüche, **dadurch gekennzeichnet, daß** die erste Phase von Behandlungen die Dotierung des Stapels umfaßt.

6. Verfahren nach Anspruch 5, **dadurch gekennzeichnet, daß** die Dotierung des Stapels die Einführung eines Dotierelements in das für die Abscheidung der ersten kontinuierlichen Schicht (3) aus Si₁₋ₓGeₓ verwendete Gasgemisch nach Abscheidung einer undotierten Si₁₋ₓGeₓ-Unterschicht umfaßt.

7. Verfahren nach einem der vorhergehenden Ansprüche, **dadurch gekennzeichnet, daß** in der Phase der Bildung des Gate (GR) des Transistors das erste Ätzen mit einem hochdichten Plasma eines aus Cl₂, N₂ und/oder NH₃ bestehenden Gasgemischs erfolgt.

8. Verfahren nach einem der vorhergehenden Ansprüche, **dadurch gekennzeichnet, daß** in der Phase der Bildung des Gate des Transistors das zweite Ätzen ein anisotropes Hauptätzen umfaßt und mit einem hochdichten Plasma eines aus Cl₂ und entweder N₂ oder NH₃ oder einem Gemisch von N₂ und NH₃ bestehenden Gasgemischs erfolgt.

9. Verfahren nach Anspruch 8, **dadurch gekennzeichnet, daß** das Hauptätzen vor dem Erreichen des Gateoxids (1), vorzugsweise 30 bis 40 nm vor dem Erreichen des Gateoxids, beendet wird.

10. Verfahren nach Anspruch 8 oder 9, **dadurch gekennzeichnet, daß** das zweite Ätzen nach dem Hauptätzen ein Überätzen mit einem hochdichten Gasplasma eines aus Cl₂ und N₂ oder NH₃ oder einem Gemisch davon und gegebenenfalls O₂ bestehenden Gasgemischs umfaßt.

11. Verfahren nach einem der vorhergehenden Ansprüche, **dadurch gekennzeichnet, daß** die Abscheidung der Verkapselungsschicht (7) auf dem Gatebereich, über dem zumindest teilweise die anorganische Maske (5) angeordnet ist, erfolgt.

12. Verfahren nach einem der vorhergehenden Ansprüche, **dadurch gekennzeichnet, daß** die anorganische Maske (5) aus einer SiO₂-Schicht, gegebenenfalls mit darüber angeordeneter SiON-Schicht, gebildet wird.

13. Verfahren nach einem der vorhergehenden Ansprüche, **dadurch gekennzeichnet, daß** es sich bei der Verkapselungsschicht (7) um eine mittels CVD-Gasplasma abgeschiedene SiO₂- oder SiON-Schicht handelt.

14. Verfahren nach Anspruch 13, **dadurch gekennzeichnet, daß** die Verkapselungsschicht eine Dicke zwischen 5 und 10 nm aufweist.

15. Verfahren nach einem der vorhergehenden Ansprüche, **dadurch gekennzeichnet, daß** die isolierenden Seitenbereiche (8) aus durch Niedertemperatur-Gasplasma abgeschiedenes SiO₂ oder aus Si₃N₄ gebildet werden.

16. Verfahren nach einem der vorhergehenden Ansprüche, **dadurch gekennzeichnet, daß** die Gateoxidschicht (1) in dem Einwaferreaktor abgeschieden wird.

17. Verfahren nach einem der vorhergehenden Ansprüche, **dadurch gekennzeichnet, daß** x zwischen 0,5 und 1 liegt.

18. Verfahren nach einem der vorhergehenden Ansprüche, **dadurch gekennzeichnet, daß** die erste kontinuierliche Schicht (3) aus Si₁₋ₓGeₓ eine Dicke zwischen 50 und 200 nm aufweist und die zweite Siliciumschicht (4) eine Dicke zwischen 50 und 200 nm aufweist.
